**Europäisches Patentamt**

**European Patent Office**

**Office européen des brevets**

(19)

(11) **EP 1 222 740 B1**

(12) **EUROPÄISCHE PATENTSCHRIFT**

(45) Veröffentlichungstag und Bekanntmachung des Hinweises auf die Patenterteilung:
**26.11.2003 Patentblatt 2003/48**

(51) Int Cl.⁷: $H03L\ 7/197$, $H03L\ 7/10$

(21) Anmeldenummer: **00949116.8**

(22) Anmeldetag: **16.06.2000**

(86) Internationale Anmeldenummer:
**PCT/DE00/01987**

(87) Internationale Veröffentlichungsnummer:
**WO 01/024374 (05.04.2001 Gazette 2001/14)**

(54) **PHASENREGELKREIS**

PHASE-LOCKING LOOP

BOUCLE A PHASE ASSERVIE

(84) Benannte Vertragsstaaten:
**DE FR GB**

(30) Priorität: **27.09.1999 DE 19946200**

(43) Veröffentlichungstag der Anmeldung:
**17.07.2002 Patentblatt 2002/29**

(73) Patentinhaber: **Infineon Technologies AG**
**81669 München (DE)**

(72) Erfinder:
• **GÖTZ, Edmund**
**D-85221 Dachau (DE)**
• **MEMMLER, Bernd**
**D-85521 Ottobrunn (DE)**

• **SCHÖNLEBER, Günter**
**D-81371 München (DE)**

(74) Vertreter: **Epping Hermann & Fischer**
**Ridlerstrasse 55**
**80339 München (DE)**

(56) Entgegenhaltungen:
**EP-A- 0 641 082**  **US-A- 5 276 408**
**US-A- 5 420 545**

• **PATENT ABSTRACTS OF JAPAN vol. 017, no. 642 (E-1466), 29. November 1993 (1993-11-29) & JP 05 206848 A (FUJITSU LTD;OTHERS: 01), 13. August 1993 (1993-08-13)**

EP 1 222 740 B1

**Beschreibung**

Die Erfindung betrifft einen Phasenregelkreis, der beispielsweise im Mobilfunk einsetzbar ist.

Der Phasenregelkreis, im folgenden auch als PLL bezeichnet, ist insbesondere bei TDMA-Mobilfunksystemen (Time Division Multiple Access) wie beispielsweise GSM (Groupe Speciale Mobile, Global System for Mobile Communication) im Multislotbetrieb anwendbar. Beim Time Division Multiple Access handelt es sich um ein Verfahren zum organisierten Zugriff auf ein Kommunikationsmedium. Die Grundidee liegt dabei in einer gleichmäßigen Aufteilung der zur Verfügung stehenden Bandbreite auf die einzelnen Teilnehmer. Es gibt einen Zeitrahmen, der bei mehreren Teilnehmern in gleich große Zeitscheiben (Time Slots) unterteilt wird, wobei jedem Teilnehmer eine Zeitscheibe zugeordnet wird. Dabei sind Einschwingzeiten gefordert, die kleiner als 250μs sind. Mit einem gewöhnlichen Integer-N-Phasenregelkreis ist eine derartig kurze Einschwingzeit jedoch kaum zu erreichen.

Aus dem Stand der Technik US 5,694,089 ist ein PLL-Frequenzsynthesizer bekannt. Der Synthesizer weist einen Referenzteiler zum Teilen des Referenzsignals auf. Weiterhin weist er einen RF-Signalteiler auf, der das Ausgangssignal eines spannungsgesteuerten Oszillators teilt. Wenn die Frequenz geändert wird, ändert sich zuerst der Teilerwert des RF-Signalteilers periodisch um einen im Mittel gebrochenen Teilerwert. Wenn sich die Frequenz annähernd umgestellt hat, wird der RF-Signalteiler in den Betriebsmodus eines konventionellen Integer-N-Teilers gebracht. Hierfür kann die Frequenz in Fractional-Betriebsmodus schnell umgestellt werden. Der RF-Signalteiler wird somit - je nach Betriebsmodus - mit verschiedenen Teilerwerten geladen. Dies hat jedoch den Nachteil, daß der Einschwingvorgang, dadurch, daß in den RF-Signalteiler neue Teilerwerte geladen werden müssen, verlangsamt wird.

Aus dem Dokument JP 5-206 848 ist ein Phasenregelkreis nach dem Oberbegriff des Anspruchs 1 bekannt.

Eine Aufgabe der Erfindung ist es, einen Phasenregelkreis anzugeben, bei dem die Einschwingdauer sehr kurz und der Störsignalanteil gering ist.

Die Aufgabe wird durch einen Phasenregelkreis mit den in Patentanspruch 1 angegebenen Merkmalen gelöst.

Weitere vorteilhafte Ausgestaltungen des erfindungsgemäßen Phasenregelkreises sind in den abhängigen Patentansprüchen angegeben.

Der erfindungsgemäße Phasenregelkreis weist einen spannungsgesteuerten Oszillator auf, der ein Oszillatorsignal erzeugt. Weiterhin ist ein erster Frequenzteiler vorgesehen, der die Frequenz des Oszillatorsignals teilt, daraus ein erstes Teilerausgangssignal erzeugt und während der Einschwingdauer des Phasenregelkreises auf einen Phasenvergleicher führt. Zusätzlich ist eine Einheit vorgesehen, die nach der Einschwingdauer des Phasenregelkreises die Frequenz des ersten Teilerausgangssignals teilt und dieses zweite Teilerausgangssignal auf den Phasenvergleicher führt. Der Phasenvergleicher vergleicht während der Einschwingdauer des Phasenregelkreises das erste Teilerausgangssignal mit einem ersten Referenzsignal und nach der Einschwingdauer des Phasenregelkreises das zweite Teilerausgangssignal mit einem zweiten Referenzsignal. Der Phasenvergleicher ist ausgangsseitig mit einer steuerbaren Ladungspumpe verbunden. Diese wiederum ist ausgangsseitig mit dem spannungsgesteuerten Oszillator verbunden.

In einer vorteilhaften Ausführungsform der Erfindung weist die Einheit des Phasenregelkreises einen zweiten Teiler und einen ersten Multiplexer mit zwei Eingängen und einem Ausgang auf. Der Ausgang des ersten Teilers ist mit dem ersten Eingang des ersten Multiplexers und der Ausgang des zweiten Teilers mit dem zweiten Eingang des Multiplexers verbunden.

In einer weiteren vorteilhaften Ausführungsform sind ein dritter und ein vierter Frequenzteiler vorgesehen, die aus einem von einem Referenzoszillator stammenden Referenzoszillatorsignal das erste und das zweite Referenzsignal erzeugen.

Vorteilhafterweise kann ein zweiter Multiplexer vorgesehen sein, der das erste oder das zweite Referenzsignal auf den Phasenvergleicher führt.

Bei einer weiteren vorteilhaften Ausgestaltungsform der Erfindung ist der dritte Frequenzteiler mit dem ersten Eingang des zweiten Multiplexers verbunden und der vierte Frequenzteiler ist mit dem zweiten Eingang des zweiten Multiplexers verbunden.

Vorteilhafterweise ist zwischen die Ladungspumpe und den spannungsgesteuerten Oszillator ein Filter geschaltet. Dadurch können störende Signalanteile unterdrückt werden.

Das Filter kann ein Tiefpaßfilter sein.

Vorteilhafterweise ist eine Steuereinheit vorgesehen, die die Multiplexer steuert.

Zusätzlich kann die Steuereinheit Parameter für die Ladungspumpe und das Filter vorgeben.

In einer weiteren Ausgestaltungsform der Erfindung weist die Einheit des Phasenregelkreises eine erste Austastschaltung zur Austastung des vom ersten Frequenzteiler stammenden Signals und eine Ausblendlogik auf, wobei die Ausblendlogik die erste Austastschaltung steuert.

Die Austastschaltung kann ein UND-Gatter sein, dessen erster Eingang mit dem Ausgang des ersten Frequenzteilers und dessen zweiter Eingang mit dem Ausgang der Ausblendlogik verbunden ist. Der Ausgang der Austastschaltung ist mit dem Phasenvergleicher verbunden.

Eine zweite Austastschaltung kann zur Austastung des Referenzsignals vorgesehen sein. Die Ausblendlogik steuert dabei die zweite Austastschaltung.

Die Steuereinheit und das Referenzsignal können zusammen die Ausblendlogik steuern.

Schließlich ist es auch von Vorteil, daß der erste Frequenzteiler mit einem Akkumulator verbunden ist und abhängig vom im Akkumulator stehenden Wert die Frequenz durch einen ersten oder einen zweiten Wert teilt.

Die Erfindung wird im folgenden anhand zweier Figuren weiter erläutert.

Figur 1      zeigt eine erste Ausführungsform des erfindungsgemäßen Phasenregelkreises.

Figur 2      zeigt eine zweite erfindungsgemäße Ausführungsform des Phasenregelkreises.

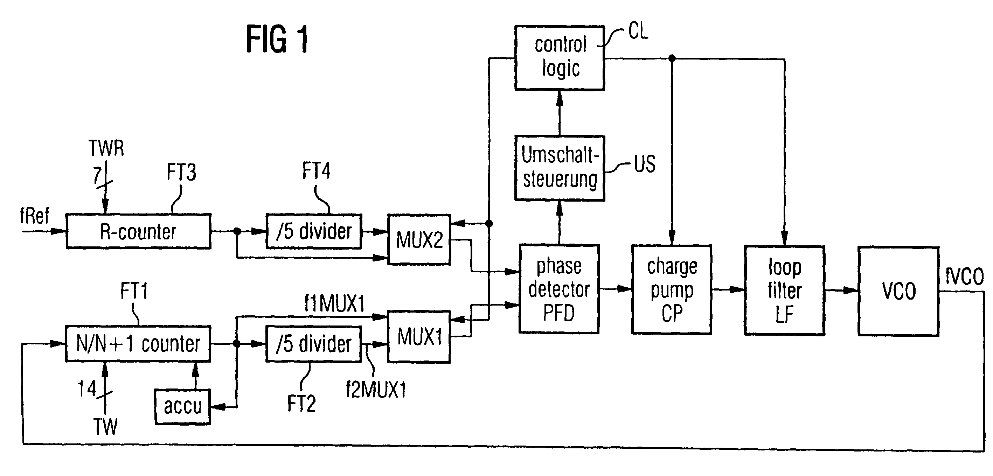

Der Phasenregelkreis weist einen spannungsgesteuerten Oszillator VCO auf, der ein Oszillatorsignal mit der Frequenz fVCO erzeugt. Dieses Oszillatorsignal wird einem ersten Frequenzteiler FT1 zugeführt, der die Frequenz fVCO durch den Teilerwert TW teilt. Der Teilerwert TW wird, wie im in Figur 1 gezeigten Ausführungsbeispiel, über eine 14Bit breite Leitung in den ersten Frequenzteiler FT1 geladen. Der Teilerwert TW wird in der Regel bei der Initialisierung des Phasenregelkreises in den ersten Frequenzteiler FT1 geladen und bleibt dann unabhängig vom Betriebszustand des Phasenregelkreises, also auch nach der Einschwingdauer des Phasenregelkreises bestehen. Lediglich wenn der Phasenregelkreis bei einer neuen Frequenz einrasten soll, wird der erste Frequenzteiler FT1 mit einem entsprechenden neuen Teilerwert TW geladen. Der erste Frequenzteiler FT1 ist mit einem Akkumulator accu, in dem ein Akkumulatorwert A gespeichert ist, verbunden. Im vorliegenden Ausführungsbeispiel ist der erste Frequenzteiler FT1 ein N/N+1-Zähler, der abhängig vom im Akkumulator accu gespeicherten Akkumulatorwert A entweder bis N oder bis N+1 zählt.

Sobald der N/N+1-Zähler den Wert N oder den Wert N+1 erreicht, liegt am Ausgang des N/N+1-Zählers ein Signal an, das unter anderem auch auf den Eingang des Akkumulators accu geführt wird. Bei dem am Ausgang des N/N+1-Zählers anliegenden Signal handelt es sich um ein digitales Signal. Sobald die Anzahl der Pegelwechsel des digitalen Signals dem im Akkumulator accu gespeicherten Akkumulatorwert A entsprechen, liefert der Akkumulator accu ein Steuersignal an den N/N+1-Zähler, der dann, wenn er bisher bis N gezählt hat, bis N+1 zählt und wenn er bisher bis N+1 gezählt hat, dann bis N zählt.

Das Ausgangssignal des ersten Frequenzteilers FT1 wird direkt dem Eingang eines ersten Multiplexers MUX1 und über einen zweiten Frequenzteiler FT2 den zweiten Eingang des Multiplexers MUX1 zugeführt. Somit liegt am ersten Eingang des ersten Multiplexers MUX1 ein Signal mit der Frequenz

$$f1MUX1 = \frac{fVCO}{N} \text{ oder } \frac{fVCO}{N + 1}$$

an. Am zweiten Eingang des ersten Multiplexers MUX1 liegt dann ein Signal mit der Frequenz

$$f2MUX1 = \frac{fVCO}{N \cdot TW2} \text{ oder } \frac{fVCO}{(N + 1) \cdot TW2}$$

an, wobei TW2 der im zweiten Frequenzteiler FT2 geladene Teilerwert ist.

Bei dem in Figur 1 gezeigten Ausführungsbeispiel beträgt der Teilerwert TW2 = 5. Der Ausgang des ersten Multiplexers MUX1 führt auf einen Phasendetektor PFD, der im folgenden auch als Phasenvergleicher bezeichnet wird.

Ein von einem Referenzoszillator stammendes Referenzoszillatorsignal mit der Referenzfrequenz fRef wird mittels eines dritten Frequenzteilers FT3 durch den Teilerwert TWR geteilt. Der Teilerwert TWR wird dem dritten Frequenzteiler FT3 über eine 7Bit breite Leitung zugeführt. Im vorliegenden Ausführungsbeispiel ist der dritte Frequenzteiler FT3 durch einen bis zum Teilerwert TWR zählenden Zähler realisiert. Am Ausgang des dritten Frequenzteilers FT3 liegt dann das durch den Teilerwert TWR geteilte Referenzoszillatorsignal mit der Frequenz

$$f1MUX2 = \frac{fREF}{TWR}$$

an, welches auf den ersten Eingang eines zweiten Multiplexers MUX geführt wird. Dieses frequenzgeteilte Signal wird zusätzlich mittels eines vierten Frequenzteilers FT4 geteilt und auf den zweiten Eingang des zweiten Multiplexers MUX2 geführt. Der vierte Frequenzteiler FT4 ist im vorliegenden Ausführungsbeispiel durch einen Teiler mit dem Teilerwert =5 realisiert. Der Ausgang des zweiten Multiplexers MUX2 ist mit dem zweiten Eingang des Phasendetektor PFD verbunden.

Eine Kontrolllogik CL steuert die beiden Multiplexer MUX1 und MUX2, so daß während der Einschwingphase des Phasenregelkreises das durch den Teilerwert TWR geteilte Referenzoszillatorsignal mit der Frequenz

$$f1MUX2 = \frac{fRef}{TWR}$$

mit dem durch den Teilerwert TW geteilten Oszillatorsignal mit der Frequenz

$$f1MUX1 = \frac{fVCO}{N} \text{ beziehungsweise } f1MUX1 = \frac{fVCO}{N + 1}$$

verglichen wird. Liegt keine Phasendifferenz mehr zwischen den beiden Signalen vor oder liegt die Phasendifferenz unterhalb eines vorgegebenen Wertes, wird durch ein entsprechendes Ausgangssignal am Phasendetektor PFD der Kontrolllogik CL über eine Umschaltsteuerung US mit geteilt, daß der eingeschwungene Zustand erreicht ist und der Phasenregelkreis nun mit den niedrigeren Frequenzen

$$f2MUX2 = \frac{fRef}{TW \cdot 5} \text{ und } f2MUX1 = \frac{fVCO}{TW \cdot 5}$$

betrieben werden soll. Das heißt, daß der Phasenvergleicher PFD nun diese niedrigeren Frequenzen miteinander vergleicht. Die Regeldifferenz zwischen den beiden an den Eingängen des Phasendetektors PFD anliegenden Frequenzen dient zur Steuerung einer Ladungspumpe CP, die einen Ausgangsstrom erzeugt, welcher über ein Schleifenfilter LF den spannungsgesteuerten Oszillator VCO ansteuert.

Die Kontrolllogik CL ist ausgangsseitig mit der Ladungspumpe CP und dem Schleifenfilter LF verbunden. Über dieses Steuerleitungen können von der Steuereinheit CL zusätzlich Parameter für die Ladungspumpe CP und das Schleifenfilter LF vorgegeben werden.

Dadurch, daß im Einschwingzustand des Phasenregelkreises hohe Frequenzen miteinander verglichen werden, kann der Regelkreis schneller einschwingen. Um jedoch Seitenlinien im Spektrum des Oszillatorsignals (Spurious) zu vermeiden, wird nach dem Einschwingen auf den Vergleich von Frequenzen, welche zusätzlich durch den zweiten Frequenzteiler FT2 beziehungsweise den vierten Frequenzteiler FT4 geteilt sind, zurückgegriffen. Dadurch sind Störungen im eingeschwungenen Zustand vermeidbar. Der Umschaltvorgang wird über die Kontrolllogik CL gesteuert, welche die entsprechenden Steuersignale an die beiden Multiplexer MUX1 und MUX2 sendet.

Während des Einschwingvorgangs arbeitet der erfindungsgemäße Phasenregelkreis im Fractional-N-Modus und im eingeschwungenen Zustand im Integer-N-Modus.

Zur Optimierung der Filterparameter des Schleifenfilters LF und der Ladungspumpenparameter der Ladungspumpe CP können von der Kontrolllogik CL entsprechende Steuersignale an die Ladungspumpe CP und das Schleifenfilter LF gesendet werden. So kann beispielsweise während des Einschwingvorgangs für das Schleifenfilter LF eine andere Grenzfrequenz erforderlich sein als im eingeschwungenen Zustand.

Der dritte Frequenzteiler FT3 kann beispielsweise ein Abwärtszähler sein. Das gleiche gilt für den ersten Frequenzteiler FT1.

Die Teilerwerte der vier Frequenzteiler FT1, FT2, FT3 und FT4 sind so einzustellen, daß an den Eingängen des Phasendetektors PFD jeweils annähernd gleiche Frequenzen miteinander verglichen werden können.

Der Teilerzyklus des ersten Frequenzteilers FT1, der angibt, wie oft durch N und wie oft durch N+1 geteilt wird, wiederholt sich abhängig vom Akkumulatorwert A. Da der erste Frequenzteiler FT1 grundsätzlich nur durch einen ganzzahligen Teilerwert TW teilen kann, wird durch den Akkumulator accu periodisch zwischen den Teilerwerten und N und N+1 umgeschaltet, so daß über eine bestimmte Zeitdauer im Mittel durch einen zwischen N und N+1 liegenden Teilerwert geteilt wird, was einem gebrochenen Teilerverhältnis entspricht. Durch den Teilerwert TW wird der Wert N festgelegt.

Die PLL arbeitet auf einer durch die Frequenzteiler FT1, FT2, FT3 und FT4 vorgegebenen Frequenz.

Wird eine neue Frequenz eingestellt, in dem die Teilerwerte TW und TWR geändert und in den ersten Frequenzteiler FT1 beziehungsweise den dritten Frequenzteiler FT3 geladen werden, folgt ein Einschwingvorgang, innerhalb welchem größere Phasenfehler entstehen. Diese Phasenfehler werden in der Umschaltsteuerung US erkannt und an die Kontrolllogik CL weitergeleitet. Die Kontrolllogik CL schaltet nun die beiden Multiplexer MUX1 und MUX2 derart, daß die beiden höherfrequenten geteilten Signale, welche also nicht zusätzlich durch den zweiten Frequenzteiler FT2 beziehungsweise den vierten Frequenzteiler FT4 geteilt wurden, auf den Phasendetektor PFT geführt werden. Somit erhöht sich die Vergleichsfrequenz am Phasendetektor PFD um den in den beiden Frequenzteilern FT2 beziehungsweise FT4 geladenen Teilerwert, im vorliegenden Ausführungsbeispiel um den Faktor 5. Es werden also pro Zeiteinheit fünfmal mehr Phasenvergleiche durchgeführt. Durch diese Maßnahme kann das Einschwingen beschleunigt werden. Zusätzlich kann in diesem Betriebsmodus der Strom für die Ladungspumpe CP und das Schleifenfilter LF entsprechend über die Kontrolllogik CL eingestellt werden. Durch diese Maßnahmen kann ein schnelles Einschwingen auf die neue Sollfrequenz bei einer stabilen Phasenregelung gewährleistet werden.

Um die in diesem Betriebsmodus auftretenden Phasensprünge, bedingt durch die Umschaltung zwischen den Werten N und N+1, zu vermeiden, was mit Störungen verbunden ist, wird nach dem Einschwingen die Vergleichsfrequenz um den Faktor 5 reduziert. Der Faktor, um den die Vergleichsfrequenz reduziert wird, hängt von äußeren Randbedingungen ab und ist auf die jeweiligen Bedürfnisse abzustimmen.

Ist der Phasenregelkreis auf den neuen Sollwert der Frequenz eingeschwungen, wird dies über den Phasendetektor PFD der Umschaltsteuerung US und damit der Kontrolllogik CL mitgeteilt. Liegt der Phasenfehler unterhalb einem eingestellten Wert, so werden die beiden Multiplexer MUX1 und MUX2 umgeschaltet und die Signale des ersten Frequenzteilers FT1 und des dritten Frequenzteilers FT3 wieder durch 5 geteilt, der Strom der Ladungspumpe CP wieder zurückgesetzt und das Schleifenfilter LF wieder umgeschaltet.

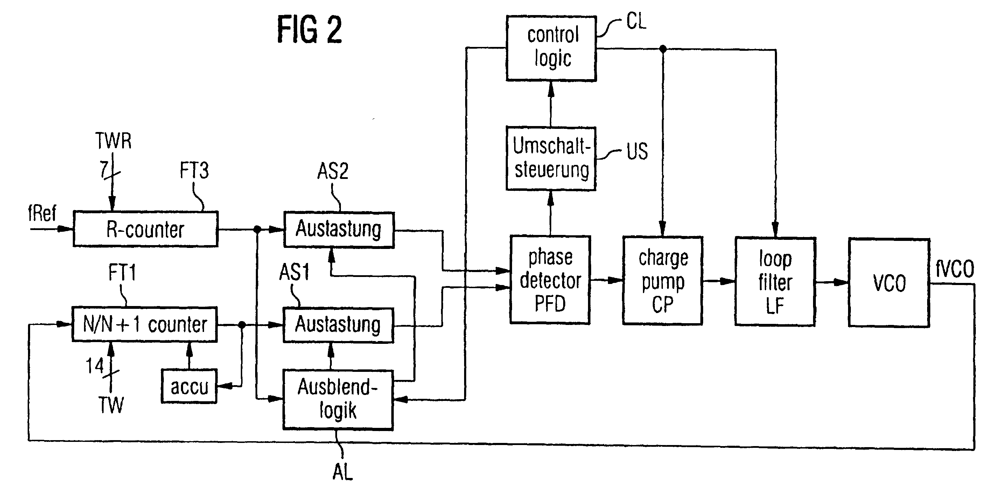

In Figur 2 ist eine zweite Ausführungsform des erfindungsgemäßen Phasenregelkreises gezeigt. Die Komponenten Phasendetektor PFD, Umschaltsteuerung US, Kontrolllogik CL, Ladungspumpe CP, Schleifenfilter LF und spannungsgesteuerter Oszillator VCO entsprechen den in Figur 1 gezeigten Komponenten. Auch der erste Frequenzteiler FT1, der dritte Frequenzteiler FT3 und Akkumulator accu in Figur 2 entsprechen den in Figur 1 gezeigten Frequenzteilern FT1 und FT3 sowie Akkumulator accu.

In Figur 2 ist der Ausgang des ersten Frequenzteilers FT1 sowohl mit dem Akkumulator accu als auch mit einer ersten Austastschaltung AS1 verbunden. Die erste Austastschaltung AS1 wird über eine Ausblendlogik AL gesteuert, welche wiederum über die Kontrolllogik CL in Verbindung mit dem dritten Frequenzteiler FT3 angesteuert wird. Der dritte Frequenzteiler FT3 ist mit dem Eingang einer zweiten Austastschaltung AS2 verbunden, welche ihrerseits ausgangsseitig mit dem Phasendetektor PFD verbunden ist. Die beiden Austastschaltungen AS1 und AS2 können beispielsweise UND-Gatter sein. Über die Ausblendlogik AL in Verbindung mit den beiden Austastschaltungen AS1 und AS2 wird gesteuert, welche Signalanteile des Ausgangssignals des ersten Frequenzteilers FT1 beziehungsweise welche Signalanteile des dritten Frequenzteilers FT3 an den Phasendetektor PFD gelangen. Durch eine gezielte Unterdrükkung bestimmter Signalanteile der Ausgangssignale des ersten Frequenzteilers FT1 beziehungsweise des dritten Frequenzteilers FT3 können Signale mit reduzierter Frequenz dem Phasendetektor PFD zugeführt werden.

Die Austastschaltungen AS1 und AS2 sind Torschaltungen, die zwischen die Ausgänge der Teiler FT1 beziehungsweise FT3 und die Phasendetektoreingänge geschaltet sind. Nur jeder nte Impuls wird damit auf den Phasendetektor PFD geleitet. Bei einem Fractional Modus von 5, wie bei GSM, wird also nur jeder fünfte Impuls dem Phasendetektor PFD zugeführt. Die Austastschaltungen AS1 und AS2 arbeiten prinzipiell so wie in Figur 1 die beiden Frequenzteiler FT2 und FT4 in Verbindung mit den beiden Multiplexern MUX1 und MUX2. Die Steuerung der beiden Austastschaltungen AS1 und AS2 wird von einem Teiler übernommen, der die beiden Austastschaltungen AS1 und AS2 zu bestimmten Zeitpunkten für einen oder mehrere Impulse öffnet. Im Fractional-N-Mode sind die beiden Austastschaltungen AS1 und AS2 nicht aktiv. Jeder Zählimpuls aus dem ersten Frequenzteiler FT1 und dem dritten Frequenzteiler FT3 wird auf den Phasendetektor PFD geleitet. Nachdem in den Integer-N-Betrieb umgeschaltet worden ist, werden die erste und die zweite Austastschaltung AS1 und AS2 aktiviert und nur noch jeder nte Impuls (n=2...16 oder auch höher) auf den Phasendetektor PFD geschaltet. Damit erhöhen sich die Teilerverhältnisse des ersten Frequenzteilers FT1 und des dritten Frequenzteilers FT3 um den Faktor n.

Vorteilhafterweise benötigt die in Figur 2 gezeigte Ausführungsform neben dem ersten Frequenzteiler FT1 und dem dritten Frequenzteiler FT3 nur mehr einen weiteren Teiler. Dieser Teiler ist Bestandteil der Ausblendlogik AL. Bei bestimmten Lösungen des Fractional-N-Betriebs kann dazu ein schon vorhandener Modulus-Zähler verwendet werden.

**Patentansprüche**

1. Phasenregelkreis,
   bei dem ein spannungsgesteuerter Oszillator (VCO) vorgesehen ist, der ein Oszillatorsignal erzeugt,
   bei dem ein erster Frequenzteiler (FT1) vorgesehen ist, der die Frequenz (fVCO) des Oszillatorsignals teilt, daraus ein erstes Teilerausgangssignal erzeugt und während der Einschwingdauer des Phasenregelkreises auf einen Phasenvergleicher (PFD) führt,
   bei dem eine Einheit (FT2, MUX1, AS1, AL) vorgesehen ist, die nach der Einschwingdauer des Phasenregelkreises die Frequenz des ersten Teilerausgangssignal teilt und auf den Phasenvergleicher (PFD) führt,
   bei dem eine weitere Einheit (FT4, MUX2, AS2, AL) vorgesehen ist, die nach der Einschwingdauer des Phasenregelkreises die Frequenz eines ersten Referenzsignals teilt, um ein zweites Referenzsignal zu erzeugen,
   bei dem der Phasenvergleicher (PFD) während der Einschwingdauer des Phasenregelkreises das erste Teilerausgangssignal mit dem ersten Referenzsignal vergleicht und nach der Einschwingdauer des Phasenregelkreises das geteilte Teilerausgangssignal mit dem zweiten Referenzsignal vergleicht,
   bei dem der Phasenvergleicher (PFD) ausgangsseitig mit einer steuerbaren Ladungspumpe (CP) verbunden ist,
   bei der die Ladungspumpe (CP) ausgangsseitig mit dem spannungsgesteuerten Oszillator (VCO) verbunden ist, **dadurch gekennzeichnet, daß**
   der erste Frequenzteiler (FT1) mit einem Akkumulator (accu) verbunden ist und abhängig vom im Akkumulator (accu) stehenden Wert (A) die Frequenz durch einen ersten oder einen zweiten Wert (N, N+1) teilt und daß
   der Phasenregelkreis ausgebildet ist, während der Eingschwingdauer in einem Fractional-N-Modus zu arbeiten und nach der Einschwingdauer in einem Integer-N-Modus zu arbeiten.

2. Phasenregelkreis nach Anspruch 1,
   bei dem die Einheit einen zweiten Teiler (FT2) und einen ersten Multiplexer (MUX1) mit zwei Eingängen und einem Ausgang aufweist,
   bei dem der Ausgang des ersten Teilers (FT1) mit dem ersten Eingang des ersten Multiplexers (MUX1) und der Ausgang des zweiten Teilers (FT2) mit dem zweiten Eingang des ersten Multiplexers (MUX1) verbunden ist.

3. Phasenregelkreis nach Anspruch 1 oder 2,
   bei der ein dritter und ein vierter Frequenzteiler (FT3, FT4) vorgesehen sind, die aus einem von einem Referenzoszillator stammenden Referenzoszillatorsignal das erste und das zweite Referenzsignal erzeugen.

4. Phasenregelkreis nach einem der Ansprüche 1 bis 3,
   bei der ein zweiter Multiplexer (MUX2) vorgesehen ist, der das erste oder das zweite Referenzsignal auf den Phasenvergleicher (PFD) führt.

5. Phasenregelkreis nach einem der Ansprüche 1 bis 4,
   bei der der dritte Frequenzteiler (FT3) mit dem ersten Eingang des zweiten Multiplexers (MUX2) und über den vierten Frequenzteiler (FT4) mit dem zweiten Eingang des Multiplexers (MUX2) verbunden ist.

6. Phasenregelkreis nach einem der Ansprüche 1 bis 5,
   bei der zwischen die Ladungspumpe (CP) und den spannungsgesteuerten Oszillator ein Filter (LF) geschaltet ist.

7. Phasenregelkreis nach Anspruch 6,
   bei der das Filter (LF) ein Tiefpaßfilter ist.

8. Phasenregelkreis nach einem der Ansprüche 1 bis 7,
   bei der eine Steuereinheit vorgesehen ist, die den Multiplexer (MUX1, MUX2) steuert.

9. Phasenregelkreis nach Anspruch 8,
   bei der die Steuereinheit zusätzlich Parameter der Ladungspumpe (CP) und des Filters (LF) vorgibt.

10. Phasenregelkreis nach Anspruch 1,
    bei der die Einheit eine erste Austastschaltung (AS1) zur Austastung des vom ersten Frequenzteiler (FT1) stammenden Signals und eine Ausblendlogik (AL) aufweist,
    bei der die Ausblendlogik (AL) die erste Austastschaltung (AS1) steuert.

11. Phasenregelkreis nach Anspruch 10,
    bei der die Austastschaltung (AS1) ein UND-Gatter ist, dessen erster Eingang mit dem Ausgang des ersten Frequenzteilers (FT1), dessen zweiter Eingang mit dem Ausgang der Ausblendlogik (AS1) und dessen Ausgang mit dem Phasenvergleicher (PFD) verbunden ist.

12. Phasenregelkreis nach Anspruch 10 oder 11,
    bei dem eine zweite Austastschaltung (AS2) zur Austastung des Referenzsignals vorgesehen ist,
    bei der die Ausblendlogik (AL) die zweite Austastschaltung (AS2) steuert.

13. Phasenregelkreis nach Anspruch 12,
    bei dem die Steuereinheit (CL) und das Referenzsignal zusammen die Ausblendlogik (AL) steuern.

## Claims

1. Phase-locked loop,
   in which a voltage-controlled oscillator (VCO) is provided, which generates an oscillator signal,
   in which a first frequency divider (FT1) is provided, which divides the frequency (fVCO) of the oscillator signal, generates a first divider output signal therefrom and passes it to a phase comparator (PFD) during the transient recovery duration of the phase-locked loop,
   in which a unit (FT2, MUX1, AS1, AL) is provided, which, after the transient recovery duration of the phase-locked loop, divides the frequency of the first divider output signal and passes it to the phase comparator (PFD),
   in which a further unit (FT4, MUX2, AS2, AL) is provided, which, after the transient recovery duration of the phase-locked loop, divides the frequency of a first reference signal in order to generate a second reference signal,
   in which the phase comparator (PFD) compares the first divider output signal with the first reference signal during the transient recovery duration of the phase-locked loop and compares the divided divider output signal with the second reference signal after the transient recovery duration of the phase-locked loop,
   in which the phase comparator (PFD) is connected, on the output side, to a controllable charge pump (CP),
   in which the charge pump (CP) is connected, on the output side, to the voltage-controlled oscillator (VCO), **characterized in that**
   the first frequency divider (FT1) is connected to an accumulator (accu) and, depending on the value (A) held in the accumulator (accu), divides the frequency by a first or a second value (N, N+1), and **in that** the phase-locked loop is designed to operate in a fractional-N mode during the transient recovery duration and to operate in an integer-N mode after the transient recovery duration.

2. Phase-locked loop according to Claim 1,
   in which the unit has a second divider (FT2) and a first multiplexer (MUX1) with two inputs and an output, in which the output of the first divider (FT1) is connected to the first input of the first multiplexer (MUX1) and the output of the second divider (FT2) is connected to the second input of the first multiplexer (MUX1).

3. Phase-locked loop according to Claim 1 or 2,

in which a third and a fourth frequency divider (FT3, FT4) are provided, which generate the first and second reference signals from a reference oscillator signal originating from a reference oscillator.

4. Phase-locked loop according to one of Claims 1 to 3,
   in which a second multiplexer (MUX2) is provided, which passes the first or the second reference signal to the phase comparator (PFD).

5. Phase-locked loop according to one of Claims 1 to 4,
   in which the third frequency divider (FT3) is connected to the first input of the second multiplexer (MUX2) and, via the fourth frequency divider (FT4), to the second input of the multiplexer (MUX2).

6. Phase-locked loop according to one of Claims 1 to 5,
   in which a filter (LF) is connected between the charge pump (CP) and the voltage-controlled oscillator.

7. Phase-locked loop according to Claim 6,
   in which the filter (LF) is a low-pass filter.

8. Phase-locked loop according to one of Claims 1 to 7,
   in which a control unit is provided, which controls the multiplexer (MUX1, MUX2).

9. Phase-locked loop according to Claim 8,
   in which the control unit additionally prescribes parameters of the charge pump (CP) and of the filter (LF).

10. Phase-locked loop according to Claim 1,
    in which the unit has a first gating circuit (AS1) for gating the signal originating from the first frequency divider (FT1) and has a blanking logic (AL),
    in which the blanking logic (AL) controls the first gating circuit (AS1).

11. Phase-locked loop according to Claim 10,
    in which the gating circuit (AS1) is an AND gate whose first input is connected to the output of the first frequency divider (FT1), whose second input is connected to the output of the blanking logic (AL) and whose output is connected to the phase comparator (PFD).

12. Phase-locked loop according to Claim 10 or 11,
    in which provision is made of a second gating circuit (AS2) for gating the reference signal,
    in which the blanking logic (AL) controls the second gating circuit (AS2).

13. Phase-locked loop according to Claim 12,
    in which the control unit (CL) and the reference signal together control the blanking logic (AL).

## Revendications

1. Boucle à verrouillage de phase dans laquelle
   il est prévu un oscillateur commandé en tension (VCO) qui génère un signal oscillant,
   il est prévu un premier diviseur de fréquence (FT1) qui divise la fréquence (fVCO) du signal oscillant, en produit un premier signal de sortie de diviseur et l'envoie à un comparateur de phases pendant la durée transitoire de la boucle à verrouillage de phase,
   il est prévu une unité (FT2, MUX1, AS1, AL) qui divise après la durée transitoire de la boucle à verrouillage de phase la fréquence du premier signal de sortie de diviseur et l'envoie ensuite au comparateur de phase (PFD),
   il est prévu une autre unité (FT4, MUX2, AS2, AL) qui divise après la durée transitoire de la boucle à verrouillage de phase la fréquence d'un premier signal de référence afin de générer un signal de référence,
   le compensateur de phase (PFD) compare pendant la durée transitoire de la boucle à verrouillage de phase le premier signal de sortie de diviseur avec le premier signal de référence et après la durée transitoire de la boucle à verrouillage de phase compare le signal de sortie de diviseur avec le deuxième signal de référence,
   le comparateur de phase (PFD) est relié en sortie à une pompe de charge commandée (CP),
   la pompe de charge (CP) est reliée en sortie avec l'oscillateur commandé en tension (VCO),
   **caractérisé en ce que**
   le premier diviseur (FT1) est relié à un accumulateur (accu) et divise en fonction de la valeur (A) se trouvant dans l'accumulateur (accu) la fréquence par une première ou une deuxième valeur (N, N+1 ) et
   la boucle à verrouillage de phase est conformée pour fonctionner pendant la durée transitoire dans un mode N fractionnaire et après la durée transitoire dans un mode N entier.

2. Boucle à verrouillage de phase selon la revendication 1, dans laquelle
   l'unité comporte un deuxième diviseur (FT2) et un premier multiplexeur (MUX1) comportant deux entrées et une sortie,
   la sortie du premier diviseur (FT1) est reliée à la première entrée du premier multiplexeur (MUX1 ) et la sortie du deuxième diviseur (FT2) est reliée à la deuxième entrée du premier multiplexeur (MUX1).

**3.** Boucle à verrouillage de phase selon la revendication 1 ou 2, dans laquelle il est prévu des troisième et quatrième diviseurs de fréquence (FT3, FT4) qui génèrent le premier signal de référence et le deuxième signal de référence à partir d'un signal oscillant de référence provenant d'un oscillateur de référence.

**4.** Boucle à verrouillage de phase selon l'une des revendications 1 à 3, dans laquelle il est prévu un deuxième multiplexeur (MUX2) qui envoie le premier ou deuxième signal de référence au comparateur de phase.

**5.** Boucle à verrouillage de phase selon l'une des revendications 1 à 4, dans laquelle le troisième diviseur (FT3) est relié à la première entrée du deuxième multiplexeur (MUX2) et par le quatrième diviseur de fréquence (FT4) à la deuxième entrée du multiplexeur (MUX2).

**6.** Boucle à verrouillage de phase selon l'une des revendications 1 à 5, dans laquelle un filtre (LF) est monté entre la pompe de charge (CP) et l'oscillateur commandé en tension.

**7.** Boucle à verrouillage de phase selon la revendication 6, dans laquelle le filtre (LF) est un filtre passe-bas.

**8.** Boucle à verrouillage de phase selon l'une des revendications 1 à 7, dans laquelle il est prévu une unité de commande qui commande le multiplexeur (MUX1, MUX2).

**9.** Boucle à verrouillage de phase selon la revendication 8, dans laquelle l'unité de commande prédétermine en plus des paramètres de la pompe de charge (CP) et du filtre (LF).

**10.** Boucle à verrouillage de phase selon la revendication 1, dans laquelle

l'unité comporte un circuit de suppression (AS1) destiné à effacer le signal provenant du premier diviseur de fréquence (FT1) et une logique de suppression,

la logique de suppression (AL) commande le premier circuit de suppression (AS1).

**11.** Boucle à verrouillage de phase selon la revendication 10, dans laquelle le circuit de suppression (AS1) est une porte ET dont une première entrée est reliée à la sortie du premier diviseur de fréquence (FT1), dont une deuxième entrée est reliée à la sortie de la logique de suppression (AS1) et dont la sortie est reliée au comparateur de phase (PFD).

**12.** Boucle à verrouillage de phase selon la revendication 10 ou 11, dans laquelle

il est prévu un deuxième circuit de suppression (AS2) destiné à supprimer le signal de référence,

la logique de suppression (AL) commande le deuxième circuit de suppression (AS2).

**13.** Boucle à verrouillage de phase selon la revendication 12, dans laquelle l'unité de commande (CL) et le signal de référence commandent conjointement la logique de suppression (AL).

FIG 1

EP 1 222 740 B1

FIG 2